# EUROPÄISCHE PATENTANMELDUNG

(11) **EP 4 324 679 A1**
(43) Veröffentlichungstag der Anmeldung: **21.02.2024**
(21) Anmeldenummer: 23186784.7
(22) Anmeldetag: 20.07.2023
(51) Int. Cl.: B60L 1/02, H01R 13/533, B60L 53/16, B60L 53/302

(54) **KÜHLKÖRPER FÜR EIN KONTAKTIERUNGSELEMENT, KONTAKTIERUNGSELEMENT FÜR EINE STECKVERBINDUNGSEINRICHTUNG SOWIE STECKVERBINDUNGSEINRICHTUNG**

(30) Priorität: 19.08.2022 DE 102022120987
(71) Anmelder: Lisa Dräxlmaier GmbH, 84137 Vilsbiburg (DE)
(72) Erfinder: Schmittat, Lutz, 84137 Vilsbiburg (DE); Heckelsmüller, Stephan, 85386 Eching (DE)

(57) **Zusammenfassung**

Die Erfindung betrifft einen Kühlkörper (1), ein Kontaktierungselement (2) mit Kühlkörper (1) sowie eine Steckverbindungseinrichtung (3) mit Kontaktierungselement (2). Der Kühlkörper (1) umfasst ein Kühlkörpergehäuse (6), das eine mit einem elektrisch nichtleitenden Kühlmittel durchströmbare Kühlmittelkammer (7) begrenzt und aus einem elektrisch leitfähigen Material ausgebildet ist. Eine Befestigungseinrichtung (8) ist am Kühlkörpergehäuse (7) ausgebildet und dazu eingerichtet, einen Kontaktierungspin (4) des Kontaktierungselements (2) außenseitig am Kühlkörpergehäuse (6) zu fixieren und dabei mit dem Kühlkörpergehäuse (6) elektrisch zu kontaktieren. Eine Einströmöffnung (16) und eine Ausströmöffnung (17) durchdringen das Kühlkörpergehäuse (6), münden in die Kühlmittelkammer (7) und sind dazu eingerichtet, außenseitig des Kühlkörpergehäuses (6) mit einem Zulaufkanal bzw. Rücklaufkanal eines Kühlmittelkreislaufs fluidisch verbunden zu werden.

## Beschreibung

### Technisches Gebiet

Die vorliegende Erfindung betrifft einen Kühlkörper für ein Kontaktierungselement einer zum Herstellen einer elektrisch leitfähigen Steckverbindung ausgebildeten Steckverbindungseinrichtung. Eine solche Steckverbindungseinrichtung findet sich insbesondere bei Kraftfahrzeugen, die eine als elektrische Sekundärbatterie ausgebildete Traktionsbatterie aufweisen, die dazu eingerichtet ist, einer elektrischen Antriebseinheit des Kraftfahrzeugs elektrische Traktionsenergie bereitzustellen. Bei dem Kraftfahrzeug handelt es sich also zum Beispiel um ein reinelektrisch antreibbares Kraftfahrzeug oder um ein Hybrid-Kraftfahrzeug. Ferner betrifft die Erfindung ein Kontaktierungselement für die Steckverbindungseinrichtung, wobei das Kontaktierungselement den Kühlkörper aufweist. Zudem betrifft die Erfindung eine Steckverbindungseinrichtung, die insbesondere kraftfahrzeugseitig angeordnet ist und zum Bilden/Schließen eines Lade- und/oder Entladestromkreises (um die Batterie zu laden bzw. zu entladen) mit einer Gegensteckverbindungseinrichtung einer Energiequelle, zum Beispiel einem infrastrukturellen Stromnetz, mechanisch und elektrisch korrespondiert.

### Stand der Technik

Heutzutage besteht der Bedarf, eine Traktionsbatterie eines ganz oder teilweise elektrisch antreibbaren Kraftfahrzeug besonders effizient und insbesondere schnell elektrisch zu laden. Durch die dabei entstehenden hohen Ladeleistungen erwärmen sich stromführenden Elemente, wie Kabel, Kontaktierungselemente (Pins) etc., wobei mit steigender Temperatur ein ohmscher Widerstand des entsprechenden stromführenden Elements steigt, was wiederum einem gewünscht hohen Maß an elektrischer Ladeleistung entgegensteht. Insbesondere aufgrund von Packaging-Vorgaben bei der Entwicklung von Kraftfahrzeugen ist ein effizientes Kühlen der stromführenden Elemente nur unter Einsatz von besonders hohem Aufwand möglich. Zudem wird die Wärmeabfuhr aufgrund einer zumeist beengten Bauraumsituation zusätzlich erschwert.

### Beschreibung der Erfindung

Aufgabe der Erfindung ist es, eine besonders hohe Ladeleistung beim Laden einer Batterie, insbesondere einer Traktionsbatterie eines Kraftfahrzeugs, zu ermöglichen.

Diese Aufgabe wird durch die Gegenstände der unabhängigen Patentansprüche gelöst. Weitere mögliche Ausgestaltungen der Erfindung sind in den Unteransprüchen, der Beschreibung und den Figuren offenbart. Merkmale, Vorteile und mögliche Ausgestaltungen, die im Rahmen der Beschreibung für einen der Gegenstände der unabhängigen Ansprüche dargelegt sind, sind zumindest analog als Merkmale, Vorteile und mögliche Ausgestaltungen des jeweiligen Gegenstands der anderen unabhängigen Ansprüche sowie jeder möglichen Kombination der Gegenstände der unabhängigen Ansprüche, gegebenenfalls in Verbindung mit einem oder mehr der Unteransprüche, anzusehen.

Gemäß der Erfindung wird ein Kühlkörper für ein Kontaktierungselement vorgeschlagen, wobei das Kontaktierungselement für eine Steckverbindungseinrichtung vorgesehen ist. Zudem schlägt die Erfindung das Kontaktierungselement vor, das den Kühlkörper und einen Kontaktierungspin aufweist, der mittels einer Befestigungseinrichtung des Kühlkörpers an dem Kühlkörper fixiert und mit diesem elektrisch kontaktiert ist. Darüber hinaus wird eine Steckverbindungseinrichtung für ein Kraftfahrzeug vorgeschlagen, mittels derer eine elektrisch leitfähige Steckverbindung zwischen einer elektrischen Energiequelle (etwa einer Ladeinfrastruktur) und einer elektrischen Batterie (etwa einer Traktionsbatterie eines Kraftfahrzeugs) herstellbar ist, indem die Steckverbindungseinrichtung und eine korrespondierende Gegensteckverbindungseinrichtung elektrisch miteinander gekoppelt werden. Auf diese Weise wird zwischen der Batterie und der Energiequelle eine elektrisch leitfähige Steckverbindung ausgebildet.

Der Kühlkörper weist ein Kühlkörpergehäuse auf, das eine mit einem elektrisch isolierenden bzw. elektrisch nichtleitenden Kühlmittel durchströmbare Kühlmittelkammer begrenzt und aus einem elektrisch leitfähigen Material ausgebildet ist. Das Kühlkörpergehäuse ist insbesondere aus einem metallischen Material, etwa einem Metall, einer Metalllegierung etc. ausgebildet. Beispielsweise kommt hierzu Kupfer in Frage, ebenso wäre auch Aluminium eine Option. Der Kühlkörper weist weiter die Befestigungseinrichtung auf, die an dem Kühlkörpergehäuse ausgebildet ist und dazu eingerichtet ist, einen Kontaktierungspin des Kontaktierungselements außenseitig an dem Kühlkörpergehäuse kraft-, form- und/oder stoffschlüssig zu fixieren und dabei den Kontaktierungspin mit dem Kühlkörpergehäuse elektrisch zu kontaktieren. Insoweit fungiert die Befestigungseinrichtung als mechanische Befestigungseinrichtung, mittels derer der Kontaktierungspin an dem Kühlkörpergehäuse mechanisch positionsfest gehalten ist, und gleichzeitig als elektrische Kontaktierungseinrichtung, mittels derer der Kontaktierungspin und das Kühlkörpergehäuse elektrisch miteinander kontaktiert sind. Dementsprechend ist der Kontaktierungspin aus einem elektrisch leitfähigen Material ausgebildet, bei dem es sich beispielsweise um das gleiche Material wie bei dem Kühlkörpergehäuse handeln kann. Der Kontaktierungspin kann als ein Hohlpin zur Aufnahme eines korrespondierenden Pins einer Gegensteckverbindungseinrichtung ausgeführt sein, dessen Kontaktierungsabschnitt in Form eines geraden Kreisringzylinders ausgeführt ist. Ferner ist ein Vollpin denkbar, der mit einer Pinaufnahme (zum Beispiel einem Hohlpin) korrespondiert, wobei der Kontaktierungsabschnitt des Vollpins in Form eines geraden Kreiszylinders ausgeführt ist. Auch ein anderer Querschnitt des Kontaktierungsabschnitts ist denkbar, zum Beispiel ein elliptischer, ovaler, polygonaler Querschnitt.

Des Weiteren weist der Kühlkörper eine Einströmöffnung und eine davon separat ausgebildete Ausströmöffnung auf, wobei die Einströmöffnung das Kühlkörpergehäuse, insbesondere eine von Gehäusewänden des Kühlkörpergehäuses, durchdringt und in die Kühlmittelkammer mündet. Die Einströmöffnung ist dazu eingerichtet, außenseitig des Kühlkörpergehäuses mit einem Zulaufkanal eines Kühlmittelkreislaufs, der beispielsweise Teil der Steckverbindungseinrichtung sein kann, fluidisch verbunden zu werden. Die Ausströmöffnung durchdringt das Kühlkörpergehäuse, insbesondere dieselbe oder eine andere der Gehäusewände des Kühlkörpergehäuses, und mündet ebenfalls in die Kühlmittelkammer. Die Ausströmöffnung ist dazu eingerichtet, außenseitig des Kühlkörpergehäuses mit einem Rücklaufkanal des Kühlmittelkreislaufs fluidisch verbunden zu werden. Der Kühlmittelkreislauf der Steckverbindungseinrichtung weist ein Kühlmittelkanalwerk (zum Beispiel ein Rohr- und/oder Schlauchwerk) und ein fluidisch in das Kühlmittelkanalwerk integriertes Kühlmittelantriebselement (eine Kühlmittelpumpe, falls als Kühlmittel eine Kühlflüssigkeit eingesetzt wird, oder ein Kühlmittelgebläse, falls als Kühlmittel ein Kühlgas eingesetzt wird) aufweist.

Die Einströmöffnung und die Ausströmöffnung sind beispielsweise kreisrund ausgebildet und können gemeinsam mit dem Kühlkörpergehäuse urgeformt sein. Die Öffnungen, das heißt die Einströmöffnung und die Ausströmöffnung, können zum Beispiel im Rahmen eines generativen und/oder additiven Herstellens des Kühlkörpergehäuses (oder eines Teils davon) oder im Rahmen eines Gießens eines Kühlkörperrohgehäuses (oder eines Teils davon) ausgebildet werden. Bei dem Kühlkörperrohgehäuse kann es sich um ein Zwischenprodukt handeln, das zum Herstellen des Kühlkörpers spanend und/oder spanlos nachbearbeitet werden kann. Die Öffnungen können alternativ in einem separaten Herstellungsprozessschritt (das heißt nach dem Urformen des Kühlkörpergehäuses bzw. Kühlkörperrohgehäuses) gebildet worden sein, etwa mittels Bohrens, Stanzens und/oder Honens und/oder Schneidens (insbesondere Laserschneidens) und/oder Fräsens etc. der entsprechenden Gehäusewand des Kühlkörpergehäuses bzw. Kühlkörperrohgehäuses. Die Kühlmittelkammer ist nach außen hin - abgesehen von den beiden Öffnungen - fluidisch dicht, sodass abseits der Öffnungen ein Austreten des Kühlmittels aus der Kühlmittelkammer heraus in eine Umgebung des Kühlkörpers verhindert ist.

Hierdurch ist eine Möglichkeit geschaffen, um einen Kontaktierungspin besonders wirksam und effizient aktiv zu kühlen. Denn im Betrieb des Kühlkörpers bzw. des Kontaktierungselements bzw. der Steckverbindungseinrichtung wird die Kühlmittelkammer mit dem Kühlmittel durchströmt bzw. durchspült, wodurch Wärme aus dem Kühlkörpergehäuse in das die Kühlmittelkammer durchströmende Kühlmittel übergeht und mittels des Kühlmittels abtransportiert wird. Die Wärme, die mittels des Kühlmittels aus dem Kühlkörpergehäuse abtransportiert wird, ist insbesondere die Wärme, die aufgrund eines den Kontaktierungspin durchfließenden elektrischen Stroms im Material des Kontaktierungspins erzeugt und über die Befestigungseinrichtung in das Material des Kühlkörpergehäuses geleitet wird. Um den Wärmeübergang zwischen dem Kontaktierungspin und dem Kühlkörpergehäuse sowie zwischen dem Kühlkörpergehäuse und dem Kühlmittel zu begünstigen, ist vorgesehen, dass als das jeweilige elektrisch leitfähige Material des Kontaktierungspins und des Kühlkörpergehäuses ein solches gewählt wird, das einen besonders hohe Wärmeleitfähigkeit aufweist. Indem im Betrieb der Kontaktierungspin und das Kühlkörpergehäuse aktiv mittels des Kühlmittels gekühlt werden, wird einem Erhöhen des ohmschen Widerstands aufgrund des fließenden Stroms wirksam entgegengewirkt, sodass im Vergleich mit ungekühlten oder passivgekühlten stromführenden Elementen besonders hohe Lade- und/oder Entladeleistungen darstellbar sind. Zusätzlich weist der Kühlkörper eine Doppelfunktionalität auf, da er im Betrieb - erstens - als Wärmesenke für den Kontaktierungspin fungiert und - zweitens - als stromführendes Element fungiert. So ist ein besonders effizientes Kühlen ermöglicht, da das stromführende Element selbst, also der Kühlkörper selbst, direkt mit dem Kühlmittel durchströmt wird. Ferner ist der Kühlkörper besonders bauraumeffizient und ausgebildet.

Einer weiteren möglichen Ausführungsform zufolge weist der Kühlkörper eine sich in die Kühlmittelkammer hineinerstreckende längliche Kühlmittellanze auf, die mit dem Kühlmittel durchströmbar ist. Eine Einströmlanzenmündung der Kühlmittellanze und eine kühlmittelkammerseitige Mündung der Einströmöffnung sind fluidisch miteinander verbunden, wobei eine Ausströmlanzenmündung der Kühlmittellanze und die kühlmittelkammerseitige Mündung der Einströmöffnung über eine freie Lanzenlänge voneinander beabstandet sind. Im Betrieb gilt also, dass das Kühlmittel durch die Einströmöffnung strömt, wodurch es zwangsläufig durch die Kühlmittellanze strömt. Mit anderen Worten strömt das Kühlmittel in die Kühlmittelkammer ein, indem es durch die Einströmöffnung hindurchströmt, unter einem Ausströmen aus der kühlmittelkammerseitigen Mündung der Einströmöffnung in die Einströmlanzenmündung einströmt und infolgedessen aus der Ausströmlanzenmündung ausströmt. Die Lanzenlänge ist dabei so gewählt, dass im Betrieb ein besonders hoher Füllgrad der Kühlmittelkammer erreicht wird und/oder besonders wirksame Kühlmittelströmungsformen in der Kühlmittelkammer auftreten. Zudem werden eine Durchströmungsdauer und eine Durchströmungslänge maximiert, wodurch der Wärmeabtransport besonders effizient erfolgt. In weiterer Ausgestaltung weist die Kühlmittellanze eine Längsschnittfigur auf, durch welche im Betrieb ein besonders vorteilhafter statischer Druck und/oder eine besonders vorteilhafte Strömungsgeschwindigkeit des aus der Ausströmlanzenmündung ausströmenden Kühlmittels erzeugt werden/wird. Beispielsweise kann die Kühlmittellanze an der Ausströmlanzenmündung einen engeren Querschnitt aufweisen als an der Einströmlanzenmündung. So wird der Wärmeabtransport mittels des Kühlmittels nochmals gesteigert.

In weiterer möglicher Ausführungsform weist der Kühlkörper für eine der Öffnungen ein Kanalkopplungselement auf. Insbesondere weist der Kühlkörper ein für die Einströmöffnung vorgesehenes, erstes Kanalkopplungselement und ein für die Ausströmöffnung vorgesehenes, zweites Kanalkopplungselement auf. Ein jeweiliges erstes Ende des jeweiligen Kanalkopplungselements schließt sich außenseitig der Kühlmittelkammer fluidisch an die entsprechende Öffnung an. Alternativ kann das jeweilige erste Ende des jeweiligen Kanalkopplungselements in die entsprechende Öffnung eingesetzt sein. Das jeweilige erste Ende kann in die Kühlmittelkammer hineinragen, das heißt von einer Wand des Kühlkörpergehäuses, durch die die entsprechende Öffnung in die Kühlmittelkammer mündet, in die Kühlmittelkammer hinein hervorspringen. Ein jeweiliges zweites Ende des jeweiligen Kanalkopplungselements dazu eingerichtet, mit dem entsprechenden Kanal, das heißt mit dem Zulaufkanal oder mit dem Rücklaufkanal, des Kühlmittelkreislaufs fluidisch verbunden zu werden. Das jeweilige Kanalkopplungselement ist zum Beispiel separat von dem Kühlkörpergehäuse, das heißt von den Öffnungen, ausgebildet und dann in die entsprechende Öffnung eingesetzt oder an die entsprechende Öffnung angesetzt und insbesondere an/in besagter Öffnung fixiert. Das Kanalkopplungselement kann beispielsweise in die entsprechende Öffnung eingeschraubt sein, wofür das Kanalkopplungselement dann an dessen erstem Ende ein Außengewinde aufweist und die entsprechende Öffnung ein mit dem Außengewinde zum Herstellen einer Gewinde- bzw. Schraubverbindung korrespondierendes Innengewinde aufweist. Für ein besonders einfaches Einschrauben des Kanalkopplungselements, insbesondere mithilfe eines Schraubwerkzeugs, kann das Kanalkopplungselement außenumfangsseitig ein Angriffselement für ein Schraubwerkzeug, etwa einen Vielkantkörper, aufweisen. Alternativ oder zusätzlich kann das Kanalkopplungselement unter Ausbildung eines Längs- oder Querpressverbands in die entsprechende Öffnung eingepresst sein. Wiederum alternativ oder zusätzlich kann das Kanalkopplungselement an/in die entsprechende Öffnung an-/eingeschweißt sein (beispielsweise mittels Reib-, Ultraschall- und/oder Laserschweißens), an-/eingeklebt, an-/eingelötet etc. In den Fällen, in denen das Kanalkopplungselement in die entsprechende Öffnung eingesetzt oder eingelegt ist, kann das Kanalkopplungselement einen Kragen aufweisen, der außenseitig an dem Kühlkörpergehäuse zum Anliegen kommt, wodurch eine bestimmungsgemäße Einbaulage des Kanalkopplungselements sichergestellt ist. Das Kanalkopplungselement und die entsprechend zugehörige der Öffnungen können gemeinsam mit dem Kühlkörpergehäuse urgeformt sein. Das Kanalkopplungselement kann zum Beispiel im Rahmen des generativen und/oder additiven Herstellens des Kühlkörpers (oder eines Teils davon) oder im Rahmen des Gießens des Kühlkörperrohgehäuses (oder eines Teils davon) ausgebildet werden. Ferner kann das Kanalkopplungselement im Rahmen eines Nachbearbeitens des Kühlkörperrohgehäuses oder des Kühlkörpergehäuses spanend und/oder spanlos ausgebildet werden. Aufgrund des jeweiligen Kanalkopplungselements ist das Kühlmittelkanalwerk des Kühlmittelkreislaufs, das heißt das Rohr- und/oder Schlauchwerk, auf besonders einfache bzw. aufwandsarme Weise an die Öffnungen und infolgedessen an die Kühlmittelkammer fluidisch anschließbar. Zudem kann das jeweilige Kanalkopplungselement als ein Winkelstück ausgeführt sein, sodass die Kanäle des Kühlmittelkanalwerks besonders vorteilhaft verlegt werden können.

In einer weiteren möglichen Ausgestaltung ist vorgesehen, dass das Kühlkörpergehäuse mittels eines spanlosen Fertigungsverfahrens und/oder mittels eines spanenden Fertigungsverfahrens hergestellt ist. Insbesondere ist das Kühlkörpergehäuse mittels Kaltfließpressens hergestellt. Wie bereits dargelegt, ist ferner ein additives bzw. generatives Fertigungsverfahren denkbar, zum Beispiel ein 3D-Drucken, ein pulverbettbasiertes (Laser-)Schmelzen etc. Alternativ oder zusätzlich kommt ein Drehen, ein Fräsen etc. in Frage, insbesondere zum Nachbearbeiten des Kühlkörperrohgehäuses, nachdem das Kühlkörperrohgehäuse spanlos hergestellt wurde. Hierdurch kann der Kühlkörper, insbesondere dessen Kühlkörpergehäuse, besonders einfach und effizient hergestellt werden. Darüber hinaus kann eine Oberflächenbearbeitung bzw. -veredelung erfolgen, beispielsweise kann das Kühlkörpergehäuse außenseitig und/oder innenseitig mit einer Korrosionsschutzbeschichtung beschichtet sein. Ferner ist es denkbar, dass die Kühlmittelkammer mit einer innenseitigen strömungsbeeinflussenden Oberflächenstruktur ausgebildet ist, zum Beispiel mit Strömungsrippen oder sonstigen Strömungslenkelementen. So wird dem Gedanken an einen effizienten kühlmittelbasierten Wärmeabtransport in besonderem Maße Rechnung getragen.

Das Kühlkörpergehäuse und infolgedessen der Kühlkörper weist in vorteilhafter Weise einen besonders einfachen Aufbau bzw. eine besonders einfache Struktur auf, wenn - wie in weiterer Ausführungsform vorgesehen ist - die Einströmöffnung und die Ausströmöffnung an einer gemeinsamen Gehäusewand, das heißt an einer ersten Gehäusewand oder an einer zweiten Gehäusewand, des Kühlkörpergehäuses angeordnet sind, das heißt dieselbe Gehäusewand durchdringen. Die Öffnungen sind also beispielsweise beide an einem Kühlmittelkammeranteil des Kühlkörpergehäuses angeordnet. Ferner kann vorgesehen sein, dass die Öffnungen beide an einem Boden bzw. Kühlmittelkammerdeckel des Kühlkörpergehäuses angeordnet sind. Kühlmittelkammeranteil und Kühlmittelkammerdeckel des Kühlkörpergehäuses werden weiter unten noch genauer erläutert.

Eine besonders vorteilhafte Durchströmung der Kühlmittelkammer mit dem Kühlmittel sowie eine besonders vorteilhafte Strömungsform des die Kühlmittelkammer durchströmenden Kühlmittel wird erreicht, wenn, wie in alternativer Ausgestaltung vorgesehen, eine der Öffnungen eine erste Gehäusewand (das heißt die erste Gehäusewand bzw. den Kühlmittelkammerdeckel oder die zweite Gehäusewand bzw. den Kühlmittelkammeranteil) des Kühlkörpergehäuses durchdringt, wobei die entsprechend andere der Öffnungen eine von der ersten Gehäusewand unterschiedliche, zweite Gehäusewand (das heißt die zweite Gehäusewand bzw. den Kühlmittelkammeranteil oder die erste Gehäusewand bzw. den Kühlmittelkammerdeckel) des Kühlkörpergehäuses durchdringt.

Eine weitere mögliche Ausführungsform sieht vor, dass das Kühlkörpergehäuse, das die Kühlmittelkammer (abgesehen von den Stellen der Einströmöffnung und der Ausströmöffnung) vollständig umschließt, ein monolithisches Teil ist. In diesem Fall sind die erste Gehäusewand und die zweite Gehäusewand und infolgedessen der Kühlmittelkammerdeckel und der Kühlmittelkammeranteil einstückig miteinander ausgebildet. Dies wird beispielsweise dadurch erreicht, wenn das Kühlkörpergehäuse generativ/additiv hergestellt ist. Dabei können die Ein- und die Ausströmöffnung beim Urformen mitausgebildet worden sein oder nach dem Urformen gebohrt/geschnitten sein. Der Kühlkörper ist daher besonders zuverlässig, da er - selbst ohne spezielle Dichtungsmaßnahmen - abseits der Öffnungen fluidisch dicht ist. Denn das Kühlmittel tritt nicht in unerwünschter Weise abseits der Öffnungen aus der Kühlmittelkammer aus und gelangt folglich nicht abseits der Öffnungen in die Umgebung des Kühlkörpers, sodass wirksam verhindert ist, dass das Kühlmittel außerhalb des Kühlkörpers und außerhalb des Kühlmittelkreislaufs Schaden verursacht.

In einer möglichen Alternative zu dem monolithischen Kühlkörpergehäuse weist es als eine erste Gehäusewand den Kühlmittelkammerdeckel und als eine zweite Gehäusewand den Kühlmittelkammeranteil auf, die zum Bilden des Kühlkörpergehäuses separat voneinander hergestellt und dann aneinander befestigt wurden. Die beiden Gehäusewände bzw. der Kühlmittelkammerdeckel und der Kühlmittelkammeranteil sind separat voneinander zum Beispiel kaltfließgepresst, gegossen, generativ/additiv hergestellt oder aus dem Vollen gefräst/gedreht oder auf sonstige Art urgeformt. Bei dem Kühlkörpergehäuse ist der Kühlmittelkammerdeckel kraft-, form- und/oder stoffschlüssig mit einer korrespondierenden Deckelöffnung des Kühlmittelkammeranteils verbunden, wodurch die Kühlmittelkammer (abgesehen von den Stellen der Einströmöffnung und der Ausströmöffnung) von dem Kühlmittelkammeranteil zusammen mit dem Kühlmittelkammerdeckel vollständig umschlossen ist. Zum Beispiel können der Kühlmittelkammerdeckel und der Kühlmittelkammeranteil reversibel zerstörungsfrei lösbar und dabei fluidisch dicht aneinander befestigt, insbesondere miteinander verschraubt sein. Die Öffnungen können beide in der ersten Gehäusewand, also im Kühlmittelkammerdeckel, ausgebildet sein. Alternativ kann vorgesehen sein, dass eine der Öffnungen, beispielsweise die Einströmöffnung, die erste Gehäusewand bzw. den Kühlmittelkammerdeckel durchdringt, wohingegen die entsprechend andere der Öffnungen, etwa die Ausströmöffnung, die zweite Gehäusewand bzw. den Kühlmittelkammeranteil durchdringt. Auch eine Ausführung des Kühlkörpers bzw. dessen Kühlkörpergehäuses, bei dem die beiden Öffnungen den Kühlmittelkammeranteil durchdringen, ist denkbar. Eine solche zwei- oder mehrteilige Ausführung des Kühlkörpergehäuses ist insofern vorteilhaft, als der Kühlkörper zum Beispiel zu Reinigungs-, Reparatur- und/oder Wartungszwecken zerlegbar ist. Zwischen dem Kühlmittelkammeranteil und dem Kühlmittelkammerdeckel kann zur Sicherung der Dichtwirkung an der Deckelöffnung ein Dichtmittel angeordnet sein, etwa eine torusförmige Ringdichtung, eine Ringscheibendichtung, eine zunächst pastöse und anschließend ausgehärtete Dichtmasse etc. Insbesondere hat der Kühlmittelkammerdeckel eine vielkantförmige Kontur, die das Handling in der Produktion begünstigt, speziell eine Beaufschlagung und Messung eines definierten Dreh- bzw. Anzugsmoments, wodurch die Qualität und die Betriebssicherheit gesteigert werden.

Für einen besonders festen bzw. zuverlässigen positionellen Sitz des Kühlkörpers in oder an einem Tragkörper, der insbesondere einen Bestandteil des Kontaktierungselements darstellt, und/oder für ein besonders einfaches Vorpositionieren des Kühlkörpers, um diesen anschließend mit dem Tragkörper besonders einfach endverbinden zu können, weist der Kühlkörper, insbesondere dessen Kühlkörpergehäuse einen festen Positionsanschlag auf. Dieser springt (beispielsweise radial) von einer Außenumfangsfläche des Kühlkörpergehäuses hervor und ist dazu eingerichtet, an einer korrespondierenden Positionsanschlagsfläche des Tragkörpers des Kontaktierungselements angelegt zu werden. Indem der Positionsanschlag an der Positionsanschlagsfläche anliegt, ist beispielsweise ein zu weites Einführen des Kühlkörpers in eine Kühlkörperaufnahmeöffnung des Tragkörpers verhindert, die von der Positionsanschlagsfläche umgeben ist. Daher ist es besonders einfach, den Kühlkörper in seine bestimmungsgemäße Einbaulage zu bringen und ihn dann gegebenenfalls zu fixieren. Der Positionsanschlag weist zum Beispiel einen nach außen hervorspringenden Kragen auf oder ist durch diesen Kragen gebildet. Ferner ist es denkbar, dass der Positionsanschlag ein Kulissenstück aufweist, das mit einer Kulissenstückaufnahme der Positionsanschlagsfläche des Tragkörpers formschlüssig korrespondiert, wodurch ein Verdrehen des Kühlkörpers in Bezug zu dem Tragkörper verhindert ist.

Insbesondere handelt es sich bei dem Tragkörper des Kontaktierungselements um einen Stromschienenkörper, der dazu eingerichtet ist, mit einem elektrischen Bordnetz des Kraftfahrzeugs elektrisch leitend verbunden zu werden. Indem der Stromschienenkörper zum einen als stromführendes Element und zum anderen als mechanisches Lager für den Kühlkörper fungiert, ist das Kontaktierungselement besonders bauteilarm und bauraumeffizient ausgebildet.

Um einen besonders sicheren bzw. festen Sitz des Kühlkörpers in/an einem Stromschienenkörper, bei dem es sich insbesondere um den Tragkörper handelt, und gleichzeitig eine besonders zuverlässige elektrische Verbindung zwischen dem Stromschienenkörper und dem Kühlkörper zu gewährleisten, weist der Kühlkörper in möglicher Weiterbildung ein erstes Verbindungselement auf, das dazu eingerichtet ist, mit einem korrespondierenden, zweiten Verbindungselement des Stromschienenkörpers des Kontaktierungselements eine kraft-, form- und/oder stoffschlüssige, jedenfalls elektrisch leitende Verbindungsvorrichtung zwischen dem Stromschienenkörper und dem Kühlkörpergehäuse zu bilden. Das erste Verbindungselement ist insbesondere außen an dem Kühlkörpergehäuse ausgebildet. Das erste Verbindungselement kann beispielsweise eine Schweißzone aufweisen, dann weist das zweite Verbindungselement eine mit der ersten Schweißzone korrespondierende, zweite Schweißzone auf. Folglich weist die Verbindungsvorrichtung des Kontaktierungselements eine Schweißverbindung auf, die zum Beispiel mittels Reib-, Ultraschall- und/oder Laserschweißens erzeugt ist. Ferner kann das erste Verbindungselement ein Außengewinde aufweisen, dann weist das zweite Verbindungselement ein korrespondierendes Innengewinde auf. Dann ergibt sich, dass die Verbindungsvorrichtung eine Schraubverbindung aufweist. Darüber hinaus kann das erste Verbindungselement das Kühlkörpergehäuse selbst aufweisen. Bei dem ersten Verbindungselement kann es sich ferner um das Kühlkörpergehäuse selbst handeln, dass dann als ein Einpresskörper gestaltet ist, wobei das zweite Verbindungselement in diesem Fall als ein korrespondierender Einpresskörpersitz ausgeführt ist. Die Verbindungsvorrichtung weist so einen aus dem Einpresskörper und dem Einpresskörpersitz gebildeten Pressverband auf. Dabei kann ein Längspressverband und/oder oder ein Querpressverband hergestellt sein. Bei letzterem kann Aufschrumpfen und/oder Kaltdehnen zum Herstellen des Pressverbandes eingesetzt werden. Es sind ferner Kombinationen der genannten Verbindungsvorrichtungen denkbar. Alternativ oder zusätzlich zu den oben genannten Verbindungseinrichtungen sind andersartige kraft-, form- und/oder stoffschlüssige und dabei jedenfalls elektrisch leitende Verbindungsvorrichtungen denkbar. So kommt beispielsweise in Frage, einen elektrisch leitfähigen Klebstoff zwischen dem Kühlkörpergehäuse und dem Stromschienenkörper zu applizieren, sodass die Verbindungsvorrichtung dann eine Klebeverbindung aufweist. Ferner können die Verbindungselemente miteinander korrespondierende Bajonettpartner aufweisen, sodass die Verbindungsvorrichtung einen Bajonettverschluss umfasst.

Bei dem Kühlkörper können gemäß einer weiteren möglichen Ausführungsform eine Längsmittenhauptachse der Befestigungseinrichtung und eine Längsmittenhauptachse des Kühlkörpergehäuses zusammenfallen. Hierdurch ist der Kühlkörper noch einfacher herstellbar, da er zumindest größtenteils mittels Drehens erzeugt werden kann.

Um bei einem vorgegebenen Pitch-Maß (das ist ein gerader Abstand zwischen zwei direkt zueinander benachbarten Kontaktierungspins derselben Kontaktierungseinheit) eine besonders voluminöse und damit den Wärmeabtransport besonders effizient unterstützende Kühlmittelkammer zu erlangen, sieht eine weitere mögliche Ausführungsform des Kühlkörpers vor, dass eine Längsmittenhauptachse der Befestigungseinrichtung und eine Längsmittenhauptachse des Kühlkörpergehäuses parallel auseinanderfallen. Dies führt zu einer exzentrischen Anordnung der Befestigungseinrichtung in Bezug zu der Kühlmittelkammer, durch welche das Pitch-Maß besonders klein vorgegeben werden kann, was wiederum eine besonders bauraumeffiziente Ausgestaltung des Kühlkörpers und infolgedessen des Kontaktierungselements ermöglicht.

Insbesondere weist der Kühlmittelkammeranteil außenseitig einen Sensorsitz auf, der dazu eingerichtet ist, einen Temperatursensor einer Temperaturmesseinrichtung zum Messen einer Temperatur des Kühlkörpers aufzunehmen. Die Temperaturmesseinrichtung ist zum Beispiel Teil des Kraftfahrzeugs, insbesondere der Steckverbindungseinrichtung. Sie ist dazu eingerichtet, im Betrieb des Kühlkörpers bzw. des Kontaktierungselements bzw. der Steckverbindungseinrichtung eine Betriebstemperatur zu überwachen. Durch die hierin beschriebene Anordnung des Temperatursensors kann besonders sicher und zuverlässig eine Temperatur des Kühlkörpers bzw. des Kontaktierungselements bzw. der Steckverbindungseinrichtung gemessen werden. Bei einer Überhitzung kann eine vorgegebene Gegenmaßnahme eingeleitet werden, beispielsweise ein Verringern der Lade-/Entladeleistung, ein Erhöhen einer Kühlleistung, ein Abbrechen des Lade-/Entladevorgangs etc. Da das Material des Kühlkörpers und das Material des Kontaktierungspins besonders gut wärmeleitend sind, ist der Temperatursensor am Kühlmittelkammeranteil hinsichtlich seiner Einbauposition besonders vorteilhaft, da die Temperatur des Kontaktierungspins und/oder des Kühlkörpers besonders genau gemessen werden kann. Zudem ist der Temperatursensor, da er außenseitig an dem Kühlkörper angeordnet ist, besonders einfach erreichbar/zugänglich. So kann der Temperatursensor mit einem Schaltungsträger, zum Beispiel einer Platine, der Steckverbindungseinrichtung besonders aufwandsarm elektrisch kontaktiert werden, insbesondere direkt auf den Schaltungsträger bzw. auf die Platine aufgesetzt werden. Dadurch ist eine besonders einfache Herstellung, insbesondere eine ganz oder teilweise automatisierte, etwa roboterunterstützte Herstellung des Kontaktierungselements und infolgedessen der Steckverbindungseinrichtung unterstützt.

Der Sensorsitz weist eine in vorteilhafter Weise besonders einfache Struktur auf und lässt sich besonders einfach und/oder aufwandsarm fertigen, wenn der Sensorsitz ein in den Kühlmittelkammeranteil gebildetes Sackloch aufweist. Ein Innendurchmesser des Sacklochs korrespondiert zumindest mit einem Außendurchmesser eines Sensorkopfes des Temperatursensors, über welchen der Temperatursensor in das Sackloch, das heißt in den Kühlmittelkammeranteil des Kühlkörpers, aufgenommen ist. Es kann vorgesehen sein, dass der Sensorkopf in das Sackloch eingesetzt ist, dabei eine Innenumfangsfläche des Sacklochs wärmeleitend berührt und positionell in dem Sackloch gehalten wird, indem der Schaltungsträger, auf/an dem der Temperatursensor fixiert ist, in Bezug zu dem Kühlkörper fixiert ist. Alternativ oder zusätzlich ist der Einsatz einer kraft-, form- und/oder stoffschlüssigen Verbindung zwischen dem Sensorkopf und dem Sackloch denkbar, etwa dass der Sensorkopf in das Sackloch eingepresst, eingeklebt etc. ist.

Insbesondere sind der Sensorsitz und die Befestigungseinrichtung an einer gemeinsamen Fläche des Kühlmittelkammeranteils angeordnet. Beispielsweise weist der Kühlmittelkammeranteil eine Stirnfläche auf, an der die Befestigungsrichtung angeordnet ist, insbesondere sich von der Stirnfläche wegerstreckt. Dies ist insbesondere bei der asymmetrischen Außengestalt des Kühlmittelkammeranteils von Vorteil, da die Stirnfläche in diesem Fall einen für den Sensorkopf ausreichen großen freien Bereich aufweist, der an die Befestigungseinrichtung angrenzt. So kann der Sensorkopf besonders nah an die Befestigungseinrichtung, und infolgedessen bei dem Kontaktierungselement besonders nah an den Kontaktierungspin, angebracht werden.

In einer weiteren möglichen Ausführungsform des erfindungsgemäßen Kontaktierungselements sind der Kühlkörper und der Kontaktierungspin einstückig miteinander ausgebildet. In diesem Zusammenhang ist zu verstehen, dass es sich bei der Befestigungseinrichtung insbesondere um einen Materialbereich handeln kann, in dem ein Material des Kontaktierungspins und ein Material des Kühlkörpers nahtlos ineinander übergehen. Das den Kontaktierungspin und das damit einstückig ausgebildete Kühlkörpergehäuse aufweisende Kontaktierungselement stellt eine besonders stabile und zuverlässige sowohl elektrische als auch mechanische Verbindung zwischen dem Kühlkörpergehäuse und dem Kontaktierungspin bereit. Zudem ist das Kontaktierungselement besonders einfach, nämlich mittels besonders weniger Prozessschritte, herstellbar.

In einer weiteren möglichen Ausführungsform sind zumindest ein Teil das Kühlkörpergehäuse, insbesondere der Kühlmittelkammeranteil desselben, und der Stromschienenkörper einstückig miteinander ausgebildet. Es kann in diesem Zusammenhang vorgesehen sein, dass der Kühlkörper, der Kontaktierungspin und der Stromschienenkörper einstückig miteinander ausgebildet sind. Insoweit handelt es sich bei der Verbindungsvorrichtung um einen Materialbereich, in dem ein Material des Kühlkörpergehäuses und ein Material des Stromschienenkörpers nahtlos ineinander übergehen. Das den Kühlkörper und den damit einstückig ausgebildeten Stromschienenkörper aufweisende Kontaktierungselement stellt eine besonders stabile und zuverlässige sowohl elektrische als auch mechanische Verbindung zwischen dem Kühlkörpergehäuse und dem Stromschienenkörper bereit. Zudem ist das Kontaktierungselement besonders einfach, nämlich mittels besonders weniger Prozessschritte, herstellbar.

Die erfindungsgemäße Steckverbindungseinrichtung weist als ein erstes Kontaktierungselement das hierin beschrieben Kontaktierungselement oder eine mögliche Ausführungsform davon auf. Ferner weist die Steckverbindungseinrichtung ein weiteres Kontaktierungselement auf, das gleich oder spiegelbildlich zu dem ersten Kontaktierungselement ausgebildet sein kann. Zudem weist die Steckverbindungseinrichtung den mit dem Kühlmittel durchströmbaren Kühlmittelkreislauf auf, der das Kühlmittelkanalwerk umfasst. Das erste Kontaktierungselement ist im Betrieb der Steckverbindungseinrichtung - zum Beispiel in einem Lade- und/oder Entladebetrieb, in dem die Traktionsbatterie des Kraftfahrzeugs elektrisch ge-/entladen wird - mittels des Kühlmittelkreislaufs kühlbar. Hierzu ist die Einströmöffnung mit dem Zulaufkanal des Kühlmittelkreislaufs fluidisch verbunden, und die Ausströmöffnung ist mit dem Rücklaufkanal des Kühlmittelkreislaufs fluidisch verbunden.

Weitere Vorteile, Merkmale und Einzelheiten der Erfindung können sich aus der nachfolgenden Beschreibung möglicher Ausführungsbeispiele sowie anhand der Zeichnung ergeben. Die vorstehend in der Beschreibung genannten Merkmale und Merkmalskombinationen sowie die nachfolgend in der Figurenbeschreibung und/oder in den Figuren allein gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

### Kurze Figurenbeschreibung

Die Zeichnung zeigt in:
- Fig. 1: in entlang einer Schnittebene II-II (siehe Fig. 2) geschnittener Ansicht ein Kontaktierungselement, das einen Kühlkörper, einen Kontaktierungspin und einen Stromschienenkörper aufweist,
- Fig. 2: in perspektivischer Ansicht eine Steckverbindungseinrichtung, die zwei spiegelbildlich ausgeführte Kontaktierungselemente aufweist,
- Fig. 3: in geschnittener Ansicht die Steckverbindungseinrichtung bzw. die Kontaktierungselemente, wobei eine jeweilige Einströmöffnung eine andere Gehäusewand eines Kühlkörpergehäuses durchdringt als eine jeweilige Ausströmöffnung,
- Fig. 4: in perspektivischer Ansicht ein Integrationsbeispiel der Steckverbindungseinrichtung,
- Fig. 5: in perspektivischer Ansicht die Steckverbindungseinrichtung teilweise bzw. die Kontaktierungselemente, wobei die Kontaktierungspins in Bezug zu dem Kühlkörper exzentrisch angeordnet sind, und
- Fig. 6: in anderer perspektivischer Ansicht die Steckverbindungseinrichtung bzw. die Kontaktierungselemente aus Fig. 5.

Gleiche und funktionsgleiche Elemente sind in den Figuren mit gleichem Bezugszeichen versehen. Im Folgenden werden ein Kühlkörper 1, ein den Kühlkörper 1 aufweisendes Kontaktierungselement 2 sowie eine das Kontaktierungselement 2 aufweisende Steckverbindungseinrichtung 3 in gemeinsamer Beschreibung erläutert.

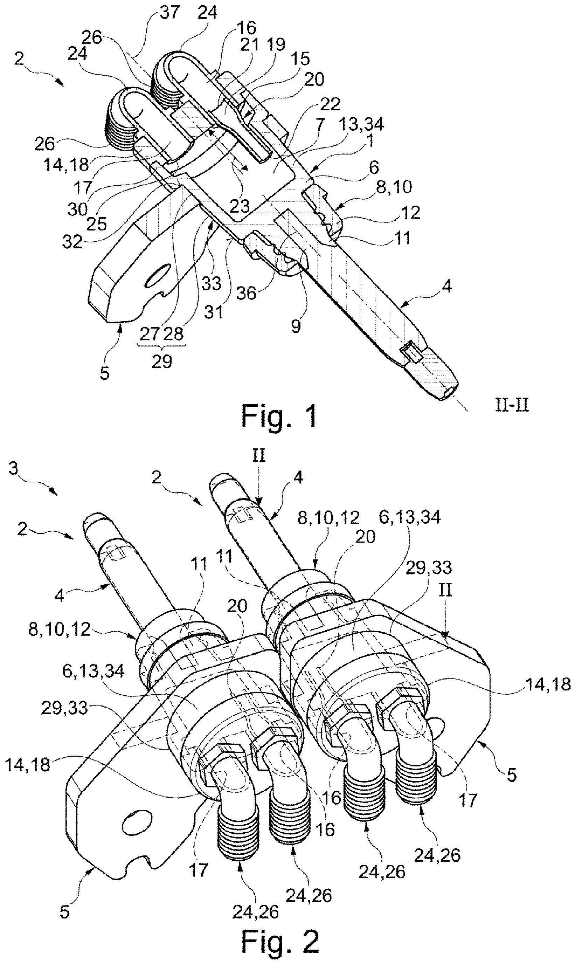

Hierzu zeigt Fig. 1 in entlang einer Schnittebene II-II (siehe Fig. 2) geschnittener Ansicht das Kontaktierungselement 2, das den Kühlkörper 1, einen Kontaktierungspin 4 und einen Stromschienenkörper 5 aufweist. Ein Kühlkörpergehäuse 6 des Kühlkörpers 1 begrenzt eine von einem elektrisch nichtleitenden Kühlmittel (nicht dargestellt) durchströmbare Kühlmittelkammer 7 und ist aus einem elektrisch leitfähigen Material, hier im Beispiel Kupfer, ausgebildet. Das Kühlkörpergehäuse 6 ist außenseitig und/oder innenseitig mit einer Korrosionsschutzbeschichtung beschichtet. Mittels einer Befestigungseinrichtung 8 des Kühlkörpers 1, ist der Kontaktierungspin 4 (hier als Vollpin ausgeführt), über dessen Befestigungsabschnitt 9 an dem Kühlkörper 1 bzw. dessen Kühlkörpergehäuse 6 fixiert und gleichzeitig elektrisch leitend mit dem Kühlkörpergehäuse 6 kontaktiert. Vorliegend weist die Befestigungseinrichtung 8 eine Spanneinheit 10 auf, in dessen Befestigungsabschnittaufnahme 11 der Befestigungsabschnitt 9 des Kontaktierungspins 4 eingesetzt ist. Zu der Spanneinheit 10 gehört zudem eine Überwurfmutter 12, mittels derer die Befestigungsabschnittaufnahme 11 an den Befestigungsabschnitt 9 gespannt ist, sodass zwischen dem Befestigungsabschnitt 9 und der Befestigungsabschnittaufnahme 11 eine kraftschlüssige und elektrisch leitende Verbindung hergestellt ist. Zumindest ein Teil der Befestigungseinrichtung 8, hier die Befestigungsabschnittaufnahme 11, und das Kühlkörpergehäuse 6 sind einstückig miteinander ausgebildet. Es ist alternativ denkbar, dass der Kontaktierungspin 4 und der Kühlkörper 1, insbesondere dessen Kühlkörpergehäuse 6, einstückig miteinander ausgebildet sind. In diesem Fall ist die Befestigungseinrichtung 8 als ein Materialübergangsbereich ausgebildet, in dem das Material des Kühlkörpergehäuses 6 und ein Material des Kontaktierungspins 4 nahtlos ineinander übergehen.

Das Kühlkörpergehäuse 6 ist zum Beispiel mittels eines spanlosen Fertigungsverfahrens und/oder mittels eines spanenden Fertigungsverfahrens hergestellt, wobei es sich bei dem Kühlkörpergehäuse 6 insbesondere um ein monolithisches Bauteil handeln kann. Insbesondere kommt zum Herstellen des Kühlkörpergehäuses 6 Kaltfließpressen zum Einsatz. Im hier erläuterten Beispiel ist das Kühlkörpergehäuse 6 zweiteilig ausgebildet und umfasst einen Kühlmittelkammeranteil 13 und einen separat davon ausgebildeten Kühlmittelkammerdeckel 14. Der Kühlmittelkammerdeckel 14 ist kraft-, form- und/oder stoffschlüssig mit einer korrespondierenden Deckelöffnung 15 des Kühlmittelkammeranteils 13 verbunden, zum Beispiel verschraubt oder in die Deckelöffnung 15 eingepresst. Die Kühlmittelkammer 7 ist so - abgesehen von einer Einströmöffnung 16 und einer Ausströmöffnung 17 - von dem Kühlmittelkammeranteil 13 zusammen mit dem Kühlmittelkammerdeckel 14 vollständig umschlossen. Es kann zudem vorgesehen sein, dass das ein Teil des Kühlkörpergehäuses 6 oder das gesamte Kühlkörpergehäuse 6 (zum Beispiel wenn dieses einstückig ausgebildet ist) und der Stromschienenkörper 5 einstückig miteinander ausgebildet sind. Insbesondere kann vorgesehen sein, dass der Kühlmittelkammeranteil 13 und der Stromschienenkörper 5 einstückig miteinander ausgebildet sind, das heißt im selben Herstellungsprozess miteinander ausgebildet werden.

Eine erste Gehäusewand 18 des Kühlkörpers 6 ist der Kühlmittelkammerdeckel 14, und eine zweite Gehäusewand 34 des Kühlkörpers 6 ist der Kühlmittelkammeranteil 13. Die Einströmöffnung 16 durchdringt die erste Gehäusewand 18, das heißt vorliegend den Kühlmittelkammerdeckel 14, des Kühlkörpergehäuses 6 und weist eine kühlmittelkammerseitige Mündung 19 auf, über welche die Einströmöffnung 16 in die Kühlmittelkammer 7 mündet. Ferner ist die Einströmöffnung 16 dazu eingerichtet, außenseitig des Kühlkörpergehäuses 6 mit einem Zulaufkanal eines Kühlmittelkreislaufs (nicht dargestellt) der Steckverbindungseinrichtung 3 fluidisch verbunden zu werden. In analoger Weise durchdringt die Ausströmöffnung 17 die erste Gehäusewand 18, also vorliegend ebenfalls den Kühlmittelkammerdeckel 14, des Kühlkörpergehäuses 6 und ist dazu eingerichtet, außenseitig des Kühlkörpergehäuses 6 mit einem Rücklaufkanal des Kühlmittelkreislaufs der Steckverbindungseinrichtung 3 fluidisch verbunden zu werden. Gemäß Fig. 1 kann also vorgesehen sein, dass die Öffnungen 16, 17 an einer gemeinsamen Gehäusewand des Kühlkörpergehäuses 6 ausgebildet sind, vorliegend an der Gehäusewand 18, die hier durch den Kühlmittelkammerdeckel 14 gebildet ist.

Fig. 1 zeigt weiter, dass der Kühlkörper 1 eine längliche Kühlmittellanze 20 aufweist, deren Einströmlanzenmündung 21 einen größeren Durchmesser als eine Ausströmlanzenmündung 22 aufweist, die über eine freie Lanzenlänge 23 von der kühlmittelkammerseitigen Mündung 19 der Einströmöffnung 16 hervorspringt. Dabei sind die Einströmöffnung 16, insbesondere deren kühlmittelkammerseitige Mündung 19, und die Einströmlanzenmündung 21 fluidisch miteinander verbunden. Des Weiteren weist der Kühlkörper 1 je Öffnung 16, 17 ein Kanalkopplungselement 24 auf, dessen jeweiliges erstes Ende 25 sich beispielsweise außenseitig der Kühlmittelkammer 7 fluidisch an die entsprechende Öffnung 16, 17 anschließt. Vorliegend ist das jeweilige erste Ende 25 des jeweiligen Kanalkopplungselements 24 in die entsprechende Öffnung 16, 17 passend eingesetzt. Jedenfalls ist ein jeweiliges zweites Ende 26 des jeweiligen Kanalkopplungselements 24 dazu eingerichtet, mit dem entsprechenden Kanal - das heißt mit dem Zulaufkanal bzw. mit dem Rücklaufkanal - des Kühlmittelkreislaufs fluidisch verbunden zu werden.

In einem Betrieb des Kühlkörpers 1 bzw. des den Kühlkörper 1 aufweisenden Kontaktierungselements 2 bzw. der das Kontaktierungselement 2 aufweisenden Steckverbindungseinrichtung 3 fungieren der Kühlkörper 1, der damit mechanisch verbundene und elektrisch kontaktierte Kontaktierungspin 4 sowie der Stromschienenkörper 5 als stromführende Elemente. Bei dem Betrieb handelt es sich zum Beispiel um einen Ladebetrieb einer Traktionsbatterie eines ganz oder teilweise elektrisch antreibbaren Kraftfahrzeugs. Im Betrieb wird mittels des Kühlmittelkreislaufs das Kühlmittel angetrieben, das dadurch durch ein Kühlmittelkanalwerk getrieben wird. Da der Zulaufkanal des Kühlmittelkreislaufs fluidisch mit der Einströmöffnung 16 verbunden ist (vorliegend mittels des in die Einströmöffnung 16 eingesetzten Kanalkopplungselements 24) wird das Kühlmittel durch das Kanalkopplungselement 24, durch die Einströmöffnung 16 und infolgedessen in die Kühlmittelkammer 7 hineingepumpt (vorliegend mittels der Kühlmittellanze 20). Dort streicht/strömt das Kühlmittel an dem Kühlkörpergehäuse 6 vorbei und nimmt dabei Wärme auf, die durch einen elektrischen Strom, der im Betrieb durch den Stromschienenkörper 5 und/oder das Kühlkörpergehäuse 6 und/oder den Kontaktierungspin 4 fließt, auf. Das so erwärmte Kühlmittel strömt dann durch die Ausströmöffnung 17, vorliegend mittels des in die Ausströmöffnung 17 eingesetzten Kanalkopplungselements 24, in den Rücklaufkanal des Kühlmittelkreislaufs, wodurch die Wärme abtransportiert wird und dementsprechend der Stromschienenkörper 5, der Kühlkörpergehäuse 6 und der Kontaktierungspin 4 gekühlt werden. So kommt es in den genannten stromführenden Bauteilen im Betrieb nicht oder nur in stark verringertem Maße zu einer wärmeinduzierten Erhöhung des ohmschen Widerstands, wodurch höhere Ladeleistungen dargestellt werden können.

Der Kühlkörper 1 weist zudem ein erstes Verbindungselement 27 auf, wobei der Stromschienenkörper 5 ein mit dem ersten Verbindungselement 27 korrespondierendes, zweites Verbindungselement 28 aufweist. Die Verbindungselemente 27, 28 sind dazu eingerichtet, eine kraft-, form- und/oder stoffschlüssige und dabei elektrisch leitende Verbindungsvorrichtung 29 zwischen dem Kühlkörpergehäuse 6 und dem Stromschienenkörper 5 zu bilden. Vorliegend weist das erste Verbindungselement 27 eine erste Schweißzone auf, und das zweite Verbindungselement 28 weist eine korrespondierende, zweite Schweißzone auf. Demnach weist die Verbindungsvorrichtung 29 eine Schweißverbindung auf, die mittels Reib-, Ultraschall- und/oder Laserschweißens erzeugt ist. Alternativ oder zusätzlich kann die Verbindungsvorrichtung 29 eine Schraub- bzw. Gewindeverbindung, einen Pressverband, eine Klebung (mit einem elektrisch leitfähigen Klebstoff), einen Bajonettverschluss etc. aufweisen.

Das Kühlkörpergehäuse 6 weist hier des Weiteren einen festen Positionsanschlag 30 aufweist, der von einer Außenumfangsfläche 31 des Kühlkörpergehäuses 6 hervorspringt bzw. der einen größeren Außenumfang als der Rest des Kühlkörpergehäuses 6 aufweist. In Fig. 1 ist dargestellt, dass der Positionsanschlag 30 - der im Beispiel als ein nach außen hervorspringender Kragen ausgeführt ist - sich radial nach außen von der Außenumfangsfläche 31 des Kühlkörpergehäuses 6 erstreckt. Der Kragen bzw. der Positionsanschlag 30 kommt bei dem Kontaktierungselement 2 bzw. bei der Steckverbindungseinrichtung 3 an einer korrespondierenden Positionsanschlagsfläche 32 des Stromschienenkörpers 5 zum Anliegen, wodurch der Kühlkörper 1 seine bestimmungsgemäße Einbaulage eingenommen hat. Indem der Positionsanschlag 30 bzw. der Kragen an der Positionsanschlagsfläche 32 anliegt, ist ein zu weites Einführen des Kühlkörpers 1 in eine Kühlkörperaufnahmeöffnung 33 des Stromschienenkörpers 5 verhindert.

Fig. 2 zeigt in perspektivischer Ansicht die Steckverbindungseinrichtung 3, die zwei spiegelbildlich ausgeführte Kontaktierungselemente 2 aufweist. Ein Gehäuse der Steckverbindungseinrichtung 3, mittels dessen insbesondere eine elektrische Isolierung zwischen den beiden Kontaktierungselementen 2 realisiert ist, ist in Fig. 2 nicht dargestellt.

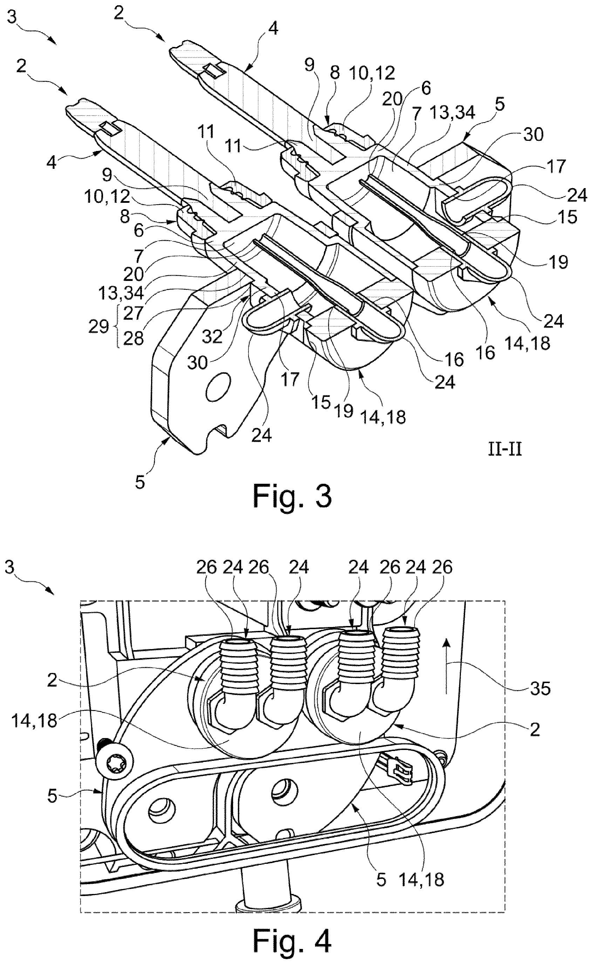

Im Unterschied zum in Fig. 1 und in Fig. 2 dargestellten Beispiel des Kühlkörpers 1, geht aus Fig. 3, die in geschnittener Ansicht die Steckverbindungseinrichtung 3 bzw. die Kontaktierungselemente 2 zeigt, hervor, dass die jeweilige Einströmöffnung 16 eine andere Gehäusewand des Kühlkörpergehäuses 6 durchdringt als die jeweilige Ausströmöffnung 17. In Fig. 3 ist dargestellt, dass die Einströmöffnung 16 die erste Gehäusewand 18 bzw. den Kühlmittelkammerdeckel 14, durchdringt, wohingegen die Ausströmöffnung 17 die beispielhaft zylindrisch ausgebildete, zweite Gehäusewand 34 bzw. den Kühlmittelkammeranteil 13, durchdringt. Zudem ist die jeweilige Kühlmittellanze 20 länger ausgeführt als in den Beispielen der Fig. 1 bzw. Fig. 2. Ansonsten unterscheiden sich der in Fig. 1 bzw. Fig. 2 und der in Fig. 3 dargestellte Kühlkörper 1 nicht.

In Fig. 4 ist eine perspektivische Ansicht eines Integrationsbeispiels der Steckverbindungseinrichtung 3 gezeigt. Es ist zu erkennen, dass die beiden Kontaktierungselemente 2 verdreht zueinander eingesetzt sein können, wodurch eine besonders geringe Breite der Steckverbindungseinrichtung 3 ermöglicht ist. Hierbei greifen die Stromschienenkörper 5 teilweise ineinander bzw. sind die Stromschienenkörper 5 in Hochrichtung 35 betrachtet einander teilweise überdeckend angeordnet.

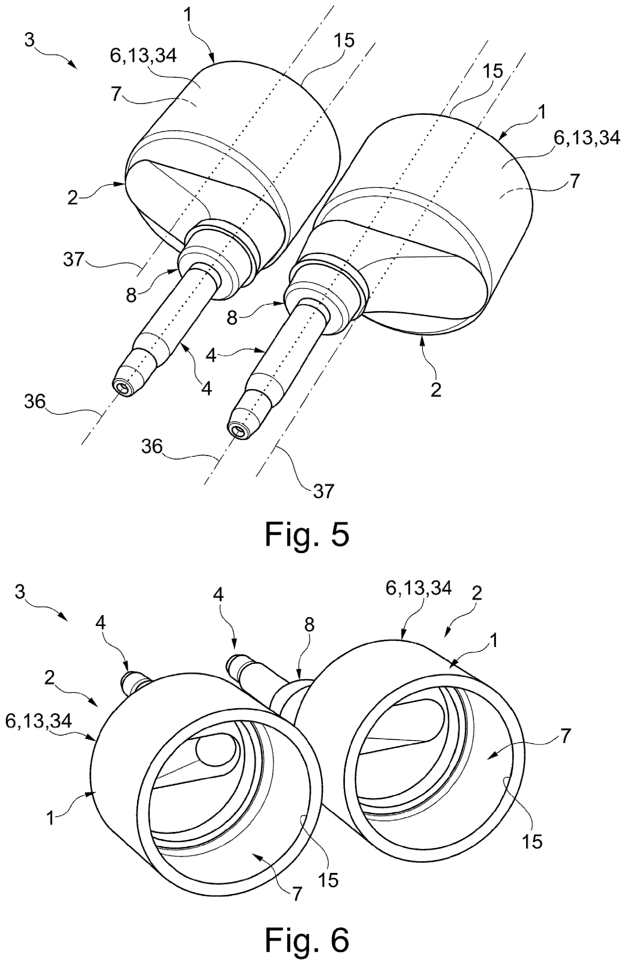

In den in Fig. 1, Fig. 2 und Fig. 3 dargestellten Beispielen des Kühlkörpers 1 fallen eine Längsmittenhauptachse 36 der Befestigungseinrichtung 9 und eine Längsmittenhauptachse 37 des Kühlkörpergehäuses 6 zusammen. Die Längsmittenhauptachsen 36, 37 sind in Fig. 1 eingezeichnet. Fig. 5 zeigt in perspektivischer Ansicht die Steckverbindungseinrichtung 3 teilweise bzw. die Kontaktierungselemente 2, wobei die Kontaktierungspins 4 in Bezug zu dem Kühlkörper 1, insbesondere zu dessen Kühlkörpergehäuse 6, exzentrisch angeordnet sind. Das bedeutet, dass in dieser Ausgestaltung die Längsmittenhauptachse 36 der Befestigungseinrichtung 9 und die Längsmittenhauptachse 37 des Kühlkörpergehäuses 6 parallel angeordnet sind und dabei auseinanderfallen.

Fig. 6 zeigt in anderer perspektivischer Ansicht die Steckverbindungseinrichtung 3 teilweise bzw. die Kontaktierungselemente aus Fig. 5. In Fig. 6 ist die jeweilige Kühlmittelkammer 7 besonders gut erkennbar.

### BEZUGSZEICHENLISTE

- 1: Kühlkörper
- 2: Kontaktierungselement
- 3: Steckverbindungseinrichtung
- 4: Kontaktierungspin
- 5: Stromschienenkörper
- 6: Kühlkörpergehäuse
- 7: Kühlmittelkammer
- 8: Befestigungseinrichtung
- 9: Befestigungsabschnitt
- 10: Spanneinheit
- 11: Befestigungsabschnittaufnahme
- 12: Überwurfmutter
- 13: Kühlmittelkammeranteil
- 14: Kühlmittelkammerdeckel
- 15: Deckelöffnung
- 16: Einströmöffnung
- 17: Ausströmöffnung
- 18: erste Gehäusewand
- 19: kühlmittelkammerseitige Mündung
- 20: Kühlmittellanze
- 21: Einströmlanzenmündung
- 22: Ausströmlanzenmündung
- 23: freie Lanzenlänge
- 24: Kanalkopplungselement
- 25: erstes Ende des Kanalkopplungselements
- 26: zweites Ende des Kanalkopplungselements
- 27: erstes Verbindungselement
- 28: zweites Verbindungselement
- 29: Verbindungsvorrichtung
- 30: Positionsanschlag
- 31: Außenumfangsfläche
- 32: Positionsanschlagsfläche
- 33: Kühlkörperaufnahmeöffnung
- 34: zweite Gehäusewand
- 35: Hochrichtung
- 36: Längsmittenhauptachse der Befestigungseinrichtung
- 37: Längsmittenhauptachse des Kühlkörpergehäuses

## Patentansprüche

1. Kühlkörper (1) für ein Kontaktierungselement (2) einer zum Herstellen einer elektrisch leitfähigen Steckverbindung ausgebildeten Steckverbindungseinrichtung (3), wobei der Kühlkörper (1) aufweist:
- ein Kühlkörpergehäuse (6), das eine mit einem elektrisch nichtleitenden Kühlmittel durchströmbare Kühlmittelkammer (7) begrenzt und aus einem elektrisch leitfähigen Material ausgebildet ist,
- eine Befestigungseinrichtung (8), die an dem Kühlkörpergehäuse (6) ausgebildet ist und dazu eingerichtet ist, einen Kontaktierungspin (4) des Kontaktierungselements (2) außenseitig an dem Kühlkörpergehäuse (6) zu fixieren und dabei den Kontaktierungspin (4) mit dem Kühlkörpergehäuse (6) elektrisch zu kontaktieren,
- eine Einströmöffnung (16), die das Kühlkörpergehäuse (6) durchdringt, in die Kühlmittelkammer (7) mündet und dazu eingerichtet ist, außenseitig des Kühlkörpergehäuses (6) mit einem Zulaufkanal eines Kühlmittelkreislaufs fluidisch verbunden zu werden,
- eine von der Einströmöffnung (16) separat ausgebildete Ausströmöffnung (17), die das Kühlkörpergehäuse (6) durchdringt, in die Kühlmittelkammer (7) mündet und dazu eingerichtet ist, außenseitig des Kühlkörpergehäuses (6) mit einem Rücklaufkanal des Kühlmittelkreislaufs fluidisch verbunden zu werden.

2. Kühlkörper (1) nach Anspruch 1,
**gekennzeichnet durch**
eine sich in die Kühlmittelkammer (7) hineinerstreckende längliche Kühlmittellanze (20), die mit dem Kühlmittel durchströmbar ist und deren Einströmlanzenmündung (21) fluidisch mit einer kühlmittelkammerseitigen Mündung (19) der Einströmöffnung (16) verbunden ist, wobei eine Ausströmlanzenmündung (22) der Kühlmittellanze (20) und die kühlmittelkammerseitige Mündung (19) der Einströmöffnung (16) über eine freie Lanzenlänge (23) voneinander beabstandet sind.

3. Kühlkörper (1) nach Anspruch 1 oder 2,
**gekennzeichnet durch**
ein Kanalkopplungselement (24), dessen erstes Ende (25) sich außenseitig der Kühlmittelkammer (7) fluidisch an eine der Öffnungen (16, 17) anschließt oder dessen erstes Ende (25) in die entsprechende Öffnung (16, 17) eingesetzt ist, wobei ein zweites Ende (26) des Kanalkopplungselements (24) dazu eingerichtet ist, mit dem entsprechenden Kanal des Kühlmittelkreislaufs fluidisch verbunden zu werden.

4. Kühlkörper (1) nach einem der vorhergehenden Ansprüche,
**dadurch gekennzeichnet, dass**
das Kühlkörpergehäuse (7) mittels eines spanlosen Fertigungsverfahrens und/oder mittels eines spanenden Fertigungsverfahrens hergestellt ist.

5. Kühlkörper (1) nach einem der vorhergehenden Ansprüche,
**dadurch gekennzeichnet, dass**
die Einströmöffnung (16) und die Ausströmöffnung (17) an einer gemeinsamen Gehäusewand (18, 34) des Kühlkörpergehäuses (6) angeordnet sind.

6. Kühlkörper (1) nach einem oder mehr der Ansprüche 1 bis 4,
**dadurch gekennzeichnet, dass**
eine der Öffnungen (16, 17) eine erste Gehäusewand (18, 34; 13, 14) des Kühlkörpergehäuses (6) durchdringt, wobei die entsprechend andere der Öffnungen (17, 16) eine von der ersten Gehäusewand (18, 34; 13, 14) unterschiedliche, zweite Gehäusewand (34, 18; 14, 13) des Kühlkörpergehäuses (6) durchdringt.

7. Kühlkörper (1) nach einem der vorhergehenden Ansprüche,
**dadurch gekennzeichnet, dass**
das Kühlkörpergehäuse (6), das die Kühlmittelkammer (7) vollständig umschließt, ein monolithisches Teil ist.

8. Kühlkörper (1) nach einem oder mehr der Ansprüche 1 bis 6,
**dadurch gekennzeichnet, dass**
das Kühlkörpergehäuse (6) einen Kühlmittelkammeranteil (13, 34) und einen separat davon ausgebildeten Kühlmittelkammerdeckel (14, 18) aufweist, wobei der Kühlmittelkammerdeckel (14, 18) kraft-, form- und/oder stoffschlüssig mit einer korrespondierenden Deckelöffnung (15) des Kühlmittelkammeranteils (13, 34) verbunden ist, wodurch die Kühlmittelkammer (7) von dem Kühlmittelkammeranteil (13, 34) zusammen mit dem Kühlmittelkammerdeckel (14, 18) vollständig umschlossen ist.

9. Kühlkörper (1) nach einem der vorhergehenden Ansprüche,
**dadurch gekennzeichnet, dass**
das Kühlkörpergehäuse (6) einen festen Positionsanschlag (30) aufweist, der von einer Außenumfangsfläche (31) des Kühlkörpergehäuses (6) hervorspringt und dazu eingerichtet ist, an einer korrespondierenden Positionsanschlagsfläche (32) eines Tragkörpers des Kontaktierungselements (2) angelegt zu werden.

10. Kühlkörper (1) nach einem der vorhergehenden Ansprüche,
**gekennzeichnet durch**
ein erstes Verbindungselement (27), das dazu eingerichtet ist, mit einem korrespondierenden, zweiten Verbindungselement (28) eines Stromschienenkörpers (5) des Kontaktierungselements (2) eine kraft-, form- und/oder stoffschlüssige elektrisch leitende Verbindungsvorrichtung (29) zwischen dem Kühlkörpergehäuse (6) und dem Stromschienenkörper (5) zu bilden.

11. Kühlkörper (1) nach einem der vorhergehenden Ansprüche,
**dadurch gekennzeichnet, dass**
eine Längsmittenhauptachse (36) der Befestigungseinrichtung (8) und eine Längsmittenhauptachse (37) des Kühlkörpergehäuses (6) zusammenfallen.

12. Kühlkörper (1) nach einem oder mehr der Ansprüche 1 bis 10,
**dadurch gekennzeichnet, dass**
eine Längsmittenhauptachse (36) der Befestigungseinrichtung (8) und eine Längsmittenhauptachse (37) des Kühlkörpergehäuses (6) parallel auseinanderfallen.

13. Kontaktierungselement (2) für eine Steckverbindungseinrichtung (3) für ein Kraftfahrzeug, wobei das Kontaktierungselement (2) einen nach einem oder mehr der vorhergehenden Ansprüche ausgebildeten Kühlkörper (1) und einen Kontaktierungspin (4), der mittels der Befestigungseinrichtung (8) an dem Kühlkörper (1) fixiert und mit diesem elektrisch kontaktiert ist.

14. Kontaktierungselement (2) nach Anspruch 13,
**dadurch gekennzeichnet, dass**
der Kühlkörper (1) und der Kontaktierungspin (4) einstückig miteinander ausgebildet sind.

15. Steckverbindungseinrichtung (3) für ein Kraftfahrzeug, mittels derer eine elektrisch leitfähige Steckverbindung zwischen einer elektrischen Energiequelle und einer elektrischen Batterie herstellbar ist, wobei die Steckverbindungseinrichtung (3) aufweist:
- als ein erstes Kontaktierungselement (2) das nach Anspruch 13 oder 14 ausgebildete Kontaktierungselement (2),
- ein weiteres Kontaktierungselement
- einen mit einem Kühlmittel durchströmbaren Kühlmittelkreislauf,
wobei das erste Kontaktierungselement (2) mittels des Kühlmittelkreislaufs kühlbar ist, indem die Einströmöffnung (16) mit einem Zulaufkanal des Kühlmittelkreislaufs fluidisch verbunden ist und die Ausströmöffnung (17) mit einem Rücklaufkanal des Kühlmittelkreislaufs fluidisch verbunden ist.
